# EUROPEAN PATENT SPECIFICATION

(11) **EP 4 275 236 B1**
(45) Date of publication and mention of the grant of the patent: **11.03.2026**
(21) Application number: 21834856.3
(22) Date of filing: 15.12.2021
(51) Int. Cl.: H10N 10/01

(54) **THERMOELECTRIC MODULE**
THERMOELEKTRISCHES MODUL
MODULE THERMOÉLECTRIQUE

(30) Priority: 05.01.2021 GB 202100094
(43) Date of publication of application: 15.11.2023
(73) Proprietor: European Thermodynamics Limited, Leicester, Leicestershire LE8 0RX (GB)
(72) Inventor: TULEY, Richard, Kibworth Leicestershire LE8 0RX (GB); KOZ, Cevriye, Kibworth Leicestershire LE8 0RX (GB); SIMPSON, Kevin, Kibworth Leicestershire LE8 0RX (GB)
(74) Representative: Barker Brettell LLP
(86) International application number: PCT/GB2021/053305
(87) International publication number: WO 2022/148944

(56) References cited:
- JP-A- 2002 359 405
- JP-A- 2005 333 083
- KR-A- 20100 070 029
- US-A1- 2005 045 702
- US-A1- 2005 139 249
- US-A1- 2011 297 203
- US-B1- 7 531 739

## Description

The present disclosure relates to a method of manufacture of a thermoelectric module.

Thermoelectric modules may be used as a heat pump for temperature control including cooling and heating or they may be used in power generation mode by utilising a heat flux. Standard thermoelectric modules require assembly of large numbers of small thermoelectric elements, of two types (n and p) in a chequerboard pattern. Standard thermoelectric module manufacturing processes involve first creating larger thermoelectric ingots or disks e.g. via zone melting, extrusion, hot pressing or spark plasma sintering. These are then cut into smaller elements, with significant waste of costly thermoelectric (TE) material in the cutting process, followed by their slow placement by hand or automated machinery onto the substrates. It would therefore be advantageous to both make the thermoelectric elements in the correct shape during production of the thermoelectric material (net shape manufacture), as well as forming them in the correct relative positions for easy module assembly. This would speed up production and reduce material wastage, reducing cost of production.

Approaches to form net shape thermoelectric material using a sinter process are disclosed in AT508979A1. It also discloses the net shape manufacture of both the n- and p-type elements simultaneously in the required relative positions for module manufacture.

US2010024437A1, DE102012205098B4 and US2013218241A1 disclose methods of net shape manufacture of both the n- and p-type elements simultaneously in the correct positions for final module construction using an egg crate, matrix material or membrane in between the thermoelectric elements.

US8198116B2 disclose methods to sinter a thermoelectric component of an n- and p-type thermoelectric element together with an electrode to form a π-shaped thermoelectric device. A plurality of π-shaped thermoelectric devices are then welded to a copper-coated ceramic plate to form an entire body. The plurality of π-shaped thermoelectric devices must still be manually positioned to form the entire body.

JP 2002 2359405 A discloses a method of making a thermoelectric module comprising a pair of comb-shaped frames which slot together to form a combined thermoelectric array. Each frame comprises a plurality of holes into which thermoelectric elements can be formed using a pair of mould plates. However, although the thermoelectric elements are formed in-situ on the frames, the thermoelectric elements formed by moulding are not net-shaped.

Previous approaches to produce net shape thermoelectric material in the correct relative positions for module assembly suffer from at least one of the two following disadvantages:
1. They use a supporting matrix or egg crate material to surround the thermoelectric elements. This provides an additional path for heat flow, decreasing the efficiency as a power generator and significantly reducing its potential as a thermoelectric heat pump.
2. They simultaneously form the n- and p-type material together. While this reduces processing steps, this means that independent optimisation of the sintering or production processes for the two different materials is not possible which may reduce performance. It also sets a minimum separation distance between the n- and p-type thermoelectric elements, due to production limits such as the minimum mould or separator size that can be used during sintering while maintaining sufficient mechanical strength.

A first aspect in accordance with claim 1 provides a method of making a combined thermoelectric array for use in a thermoelectric module comprising
(a) forming an n-type thermoelectric array, by forming at least three net shaped n-type thermoelectric elements in-situ on a first frame such that the n-type thermoelectric elements are in the correct relative positions for the thermoelectric module;
(b) forming a p-type thermoelectric array, by forming at least three net shaped p-type thermoelectric elements in-situ on a second frame such that the p-type thermoelectric elements are in the correct relative positions for use in the thermoelectric module; and
(c) slotting together the n-type thermoelectric array and the p-type thermoelectric array, thereby creating a combined thermoelectric array, in which both the n-type elements and the p-type elements are in the correct relative positions for the thermoelectric module.

By providing the n-type and p-type thermoelectric arrays in different steps, the separation distance between the n-type and p-type thermoelectric elements in the ensuing thermoelectric module can be lower. A lower separation between n-type and p-type thermoelectric elements may be desirable as it can increase performance, for example increasing cooling or heating power density.

The n-type thermoelectric elements, or the p-type thermoelectric elements, or both the n-type and p-type thermoelectric elements may be formed by a sintering process.

The first frame and second frame may be positioned near to or at opposing ends of the n-type and p-type thermoelectric elements respectively. The first frame and the second frame may not allow the thermoelectric arrays to fully pass through one another when slotted together. In some embodiments the frames may be able to pass through one another. The first frame and the second frame may be positioned up to or at least 5%, up to or at least 10%, up to or at least 20%, up to or at least 30%, up to or at least 40% and/or up to 50% of the length of the n-type and p-type thermoelectric elements from an end of the n-type and p-type thermoelectric elements.

A third frame may be connected near to or at the opposing ends of the n-type thermoelectric elements to the first frame. A fourth frame may be connected near to or at the opposing ends of the p-type thermoelectric elements to the second frame.

At least one of the frames may comprise a plurality of frame elements, for example one frame element for each mechanical connection between the frame and a thermoelectric element. At least one of the frames may extend into one or more thermoelectric elements. At least one of the frames may extend across one or more thermoelectric elements. At least one of the frames may comprise a single unitary portion.

One or more of the frames may comprise a metal. One or more of the frames may comprise nickel.

The method may comprise a step of joining the combined thermoelectric array to at least one interconnect and at least one substrate to form the thermoelectric module. The method may comprise a step of joining the combined thermoelectric array to a plurality of interconnects, the interconnects being disposed on one or more substrates, to form the thermoelectric module. The one or more substrates may comprise electrically insulating material. A top substrate and a bottom substrate may be used. One or more electrical interconnects may be disposed on each of the bottom substrate and the top substrate. Each interconnect may electrically connect alternating n-type thermoelectric elements and p-type thermoelectric elements in series, thereby forming a string of electrically connected thermocouples.

Advantageously, through use of a first frame and a second frame the combined thermoelectric arrays may be joined or connected to the electrical interconnects and substrates without requiring alignment of each individual thermoelectric element to form a thermoelectric module.

The combined thermoelectric array(s) may be joined or connected to the electrical interconnects and substrates by any suitable means such as soldering or brazing.

Joining or connecting the combined thermoelectric array(s) to the electrical interconnects and substrates may be made in two steps, with a separate step for each substrate and associated electrical interconnects. Joining or connecting the combined thermoelectric assembly with the substrates and their electrical interconnects may occur in one step.

The thermoelectric elements may undergo a further processing step and may be ground, lapped or polished. This step may be carried out after the thermoelectric elements are joined or connected to a substrate and electrical interconnects. Such a process may narrow the range of heights of the thermoelectric elements.

One or more external wires may be connected to at least one interconnect to allow external electrical connection. Individual electrical wires may be connected to at least two separate interconnects. The thermoelectric module may be electrically connected to an external power source via one or more external wires to provide, in use, electrical cooling or heating, or be thermally connected across a temperature difference, in use, between the top and bottom substrates, to generate electrical power.

Following the optional step of joining the combined thermoelectric array to at least one interconnect and at least one substrate, the first frame and/or the second frame may be at least partially removed from the thermoelectric module. This may avoid possible electrical interconnection of the thermoelectric elements through the frames.

One or more of the n-type thermoelectric elements and/or one or more of the p-type thermoelectric elements may comprise one or more bismuth telluride-based compounds.

The n- and p-type thermoelectric arrays may comprise minimum separation distances between the thermoelectric elements. Some points on the thermoelectric element surfaces may have greater separation distances to the nearest thermoelectric element.

In an example implementation, the minimum thermoelectric element separation in the n-type and p-type thermoelectric arrays may be 1.41 times higher than the minimum thermoelectric element separation in the combined thermoelectric array, which will correspond to the minimum thermoelectric element separation in a thermoelectric module.

For example, the wall thicknesses of the moulds or dies required during formation by sintering of the n-type and p-type elements correspond to the thermoelectric element separations, and are also governed by minimum thicknesses to ensure adequate mould or die mechanical strength during the thermoelectric material formation process e.g. during pressing and sintering. Advantageously therefore, if a minimum die or mould thickness of *MDT* is required for mechanical strength, this method allows a minimum thermoelectric element separation in the module of *MDT*/*1.41.* In contrast, processes that simultaneously sinter the n-type and p-type material in one step comprise a minimum thermoelectric element separation given by *MDT.* Lower thermoelectric element separation in the thermoelectric module can be beneficial for improving performance, for example to improve heat pumping power per unit area in cooling or heating mode, or to increase electrical power produced per area when subject to a temperature difference.

The thermoelectric elements may be formed by any suitable process. The thermoelectric elements may be formed by sintering processes including but not limited to hot pressing, spark plasma sintering, hot isostatic pressing, extrusion or cold pressing followed by heat treatment. Cold pressing may also precede the other formation processing steps to increase ease of handling.

The thermoelectric elements may be formed by other 3D manufacturing processes, including printing, casting or dispensing, optionally followed by heat treatment; and selective laser melting. While these may not require a mould or die, limitations in material slumping, the minimum resolution of print/dispense/laser heads or printing screens/stencils for example will lead to a minimum value on thermoelectric element separation that can be made in one formation step, analogous to *MDT.* Therefore, the separate formation of the n-type and p-type elements described in this invention can still beneficially reduce the thermoelectric element separation in the thermoelectric module.

One or more of the thermoelectric elements may comprise chamfered or rounded corners. This may reduce mechanical stress concentrations, improving robustness in the module. In addition it can decrease the minimum thermoelectric spacing in the final module while maintaining the same *MDT* during manufacture of the thermoelectric arrays. It may also improve release from the die or mould during thermoelectric array formation if a mould or die is required.

In an embodiment the shape of the thermoelectric elements in plan view may be circular, thus forming cylindrical thermoelectric elements. This can reduce mechanical stress concentrations, improving robustness in the module and if a mould or die is required during formation it may also improve release from the die or mould during thermoelectric array formation.

In an embodiment the shape of the thermoelectric elements in side view may be tapered, for example to aid release from a mould or die.

One or more of the frames may comprise an electrical insulator. One or more of the frames may comprise an electrical conductor. One or more of the frames may comprise the same thermoelectric material as the thermoelectric elements. One or more of the frames may comprise a metal, for example copper, silver, nickel, iron, cobalt, molybdenum or gold. One or more of the frames may comprise a wire, ribbon or foil. One or more frames may comprise more than one layer. One or more of the frames may be formed by cutting from a foil e.g. by die cutting.

In embodiments where one or more of the frames comprise an electrical conductor, the frame(s) may provide an electrical short circuit of the thermoelectric elements thereby reducing performance. Therefore, after mounting the combined thermoelectric array to either a temporary substrate or to electrical interconnects and a substrate an optional step may be provided of cutting the frames along cut lines resulting in removal of the frame's electrical short circuits. While this adds a further step to the method, compared to the conventional process this cutting process does not waste thermoelectric material, and can be performed at significantly higher speed, as only small quantities of frame material may need to be removed. With correct choice of cutting blade or wire saw width, this cutting process may also be used to remove any undesirable imperfections in the edges of the thermoelectric elements caused by edge effects during production. Other methods of cutting one or more frame may also be used such as laser cutting or water jet cutting.

Each frame may extend across a substantial portion of the thermoelectric area. One or more frames may function as a supporting structure and also a metallisation layer on the thermoelectric elements. A metallisation layer may aid soldering of the thermoelectric elements to the electrical interconnects, and may act as a diffusion barrier. A diffusion barrier may reduce the degradation of performance with time of operation, especially at elevated temperatures.

In some embodiments two frames may be used for each thermoelectric element type, one at each end of the thermoelectric elements, so that two frames are used for each of the n-type thermoelectric array and the p-type thermoelectric array, making four frames in the combined thermoelectric assembly. The frames connected to a first end of each of the n-type and p-type thermoelectric elements may be configured such that they can pass through each other, while the frames connected at an opposing second end of each of the n-type and p-type thermoelectric elements may be configured such that they cannot pass through each other. The frames configured such that they cannot pass through each other may provide increased mechanical strength. In this configuration metallisation layers can be applied to both sides of the thermoelectric elements while achieving net shape thermoelectric element manufacture and keeping the required relative spacing of the thermoelectric elements for the thermoelectric module.

One or more of the frames may extend outside the minimum sized envelope required to enclose the thermoelectric elements. The minimum sized envelope may be a minimum sized rectangle.

One or more of the frames may comprise a thickness of up to 10 mm, up to 5 mm, up to 4 mm, up to 3 mm, up to 2 mm or up to 1 mm. One of more of the frames may have a thickness of at least 5 microns or at least 10 microns. One or more of the frames may comprise a thickness in the range of from 5 to 1000 microns, from 5 to 500 microns, from 5 to 300 microns, from 10 to 1000 microns, from 10 to 500 microns or from 10 to 300 microns.

The separation between adjacent thermoelectric elements in the module may be 5 mm or less, 4 mm or less, 3 mm or less, 2 mm or less or 1 mm or less.

In example embodiments, the separation between adjacent thermoelectric elements in the module may be 0.5 mm or less or 0.25 mm or less.

The number of thermoelectric elements attached to each frame may be at least four, at least eight or at least 16. The number of thermoelectric elements attached to each frame may be up to 32, up to 64, up to 128, up to 256 or up to 1024.

A single thermoelectric module may be produced from an array comprising a plurality of combined thermoelectric arrays. Smaller combined thermoelectric arrays may be made with a higher yield, while the use of the combined thermoelectric arrays may significantly reduce the number of individual items to place and align. For example, a thermoelectric module may be formed of 256 thermoelectric elements by using four combined thermoelectric arrays each having 64 thermoelectric elements.

The n- and/or p-type thermoelectric elements may comprise any suitable material or combination of materials such as: bismuth telluride; bismuth selenide; antimony telluride; lead telluride; lead selenide; magnesium silicide; magnesium stannide; higher manganese silicide; skutterudite materials; Half Heusler alloys; silicon-germanium, oxides and combinations of the above. Suitable thermoelectric materials may also include any binary, tertiary or quaternary compound, or any chemical composition, of the above-listed elements (or any other elements), that exhibits favourable thermoelectric properties. The thermoelectric material may be crystalline or amorphous. The thermoelectric materials may also comprise any suitable combination of dopants and/or other additives that may alter the chemical composition and/or thermoelectric properties.

The substrates may comprise electrically insulating, thermally conductive materials such as aluminium oxide, aluminium nitride or beryllium oxide. The electrical interconnects may be made of a conductive metal such as silver, copper or aluminium, for example.

Advantageously, the invention may provide a method to form the n-type and p-type thermoelectric material in the correct shape for the final thermoelectric elements, in the correct positions for final module assembly, without using an egg crate or matrix material, and utilizing separate n-type and p-type production steps to enable potential reduction in spacing between the thermoelectric elements. This is done by utilizing at least one frame on the p-type thermoelectric elements, and at least one frame on the n-type thermoelectric elements. The frame is designed so that it holds the n-type and p-type thermoelectric elements in the correct relative positions, even after being removed from the forming equipment. The forming equipment may comprise sintering equipment. Example sintering equipment or systems may comprise, for example, a mould or die for a hot press or spark plasma sintering system.

In addition the frames are designed such that the n-type and p-type thermoelectric elements on each frame may be slotted together to form the correct relative positions for final module assembly without complete removal of the frames.

An aspect provides a method of making a thermoelectric module manufactured in accordance with the present disclosure.

Embodiments will now be described, by way of example only, with reference to the accompanying drawings, in which:
Figure 1 is a schematic representation of a conventional thermoelectric module;
Figure 2 is a plan view of the layout of the thermoelectric elements within a thermoelectric module such as shown in Figure 1;
Figure 3A shows a plan view of the n-type thermoelectric elements and the frame according to an embodiment;
Figure 3B shows a side view of the n-type thermoelectric elements and the frame according to an embodiment;
Figure 4A shows a plan view of the p-type thermoelectric elements and the frame according to an embodiment;
Figure 4B shows a side view of the p-type thermoelectric elements and the frame according to an embodiment;
Figure 5A shows a plan view of the n- and p-type thermoelectric elements assembled together with their respective frames;
Figure 5B shows a side view of the n- and p-type thermoelectric elements assembled together with their respective frames;
Figure 6A shows a plan view of the n- and p-type thermoelectric elements assembled together with their respective frames with cut lines to isolate the frames;
Figure 6B shows a plan view of the n- and p-type thermoelectric elements assembled together with their respective frames after cutting along the cut lines to isolate the frames;
Figure 7A shows a plan view of the n-type thermoelectric elements and the frame according to an embodiment;
Figure 7B shows a plan view of the frame according to an embodiment;
Figure 7C shows a side view of the n-type thermoelectric elements and the frame according to an embodiment; and
Figure 8 shows a plan view of the p-type thermoelectric elements and its frame and the n-type thermoelectric elements and its frame according to an embodiment.

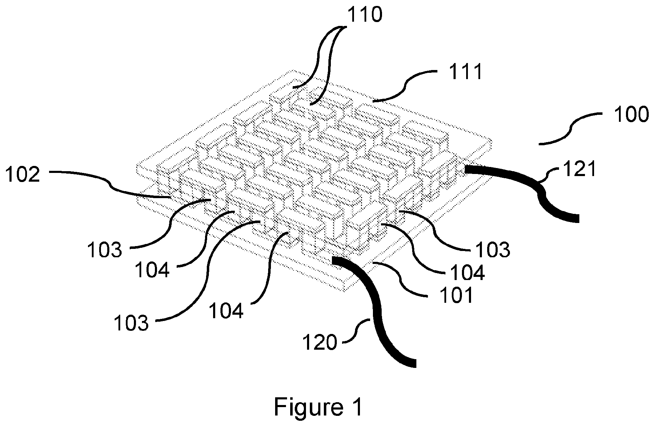

An example standard thermoelectric module 100 as is known in the art is shown in Figure 1. The thermoelectric module 100 comprises an electrically insulating bottom substrate 101, electrical interconnects 102 disposed on the bottom substrate 101, alternating n-type thermoelectric elements 104 and p-type thermoelectric elements 103, and electrical interconnects 110 disposed on an electrically insulating top substrate 111. The top substrate 111 is shown as transparent for clarity of the drawing. The electrical interconnects 102, 110 connect the n-type 104 and p-type 103 thermoelectric elements in series, thereby forming a string of electrically connected thermocouples. External wires 120, 121 allow external electrical connection. Such a thermoelectric module may be electrically connected to an external power source to provide electrical cooling or heating, or be thermally connected across a temperature difference between the substrates 101, 111 to generate electrical power.

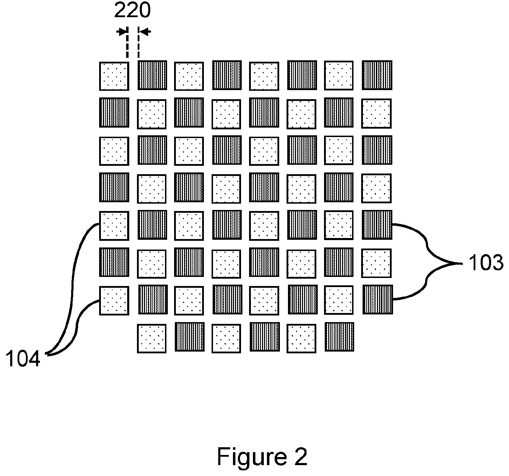

Figure 2 shows a plan view of the layout of the n-type 104 and p-type 103 thermoelectric elements within the module 100 shown in Figure 1, and shows the minimum separation 220 between adjacent thermoelectric elements 103, 104.

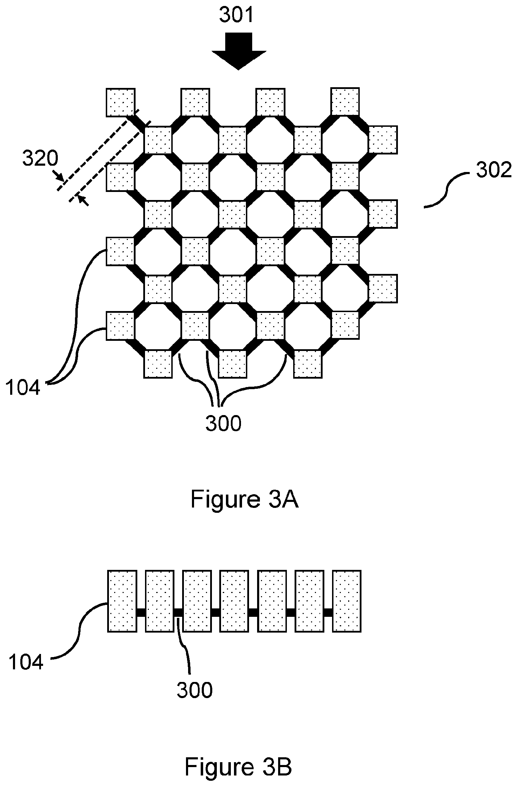

Figure 3A shows an embodiment where the n-type thermoelectric elements 104 are produced in their final shape, with the correct relative positioning for the thermoelectric module, with the help of a first frame 300, to form an n-type thermoelectric array 302. The first frame 300 acts to mechanically connect the n-type thermoelectric elements 104 to each other, allowing the n-type thermoelectric elements 104 to keep their relative positions even after removal from the equipment used to form the n-type thermoelectric array 302. For example, the first frame 300 allows the n-type thermoelectric elements 104 to keep their relative positions after removal from a sintering system, for example a mould or die for a hot press or spark plasma sintering system.

Figure 3B shows a side view of the thermoelectric array 302 from a viewing position 301, illustrating that the first frame 300 may not be centrally positioned vertically on the n-type thermoelectric elements 104. The first frame 300 may comprise a number of different frame elements, for example one element for each mechanical connection that the first frame 300 provides between n-type thermoelectric elements 104. The first frame 300 may extend into or across the n-type thermoelectric elements 104. The first frame 300 may be a single piece.

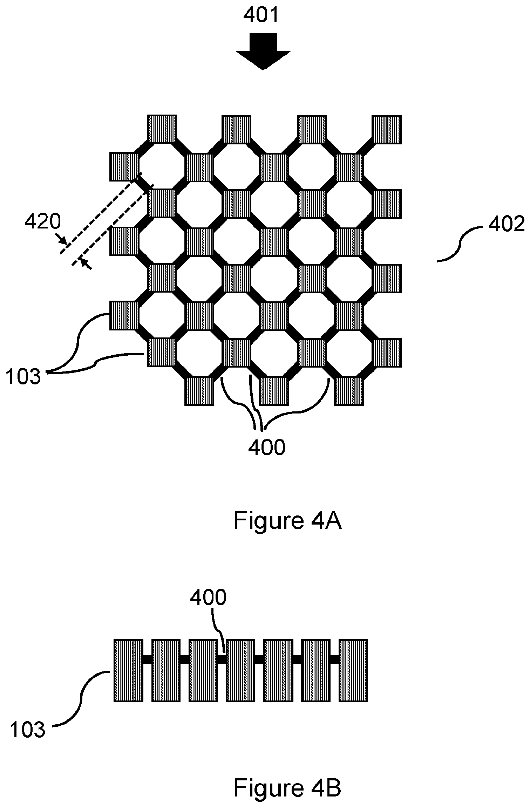

Figure 4A shows the p-type thermoelectric elements 103 are produced in their final shape, with the correct relative positioning for the thermoelectric module, with the help of a second frame 400, to form a p-type thermoelectric array 402. The second frame 400 acts to mechanically connect the p-type thermoelectric elements 103 to each other, allowing the p-type thermoelectric elements 103 to keep their relative positions even after removal from the equipment used to form the p-type thermoelectric array 402.

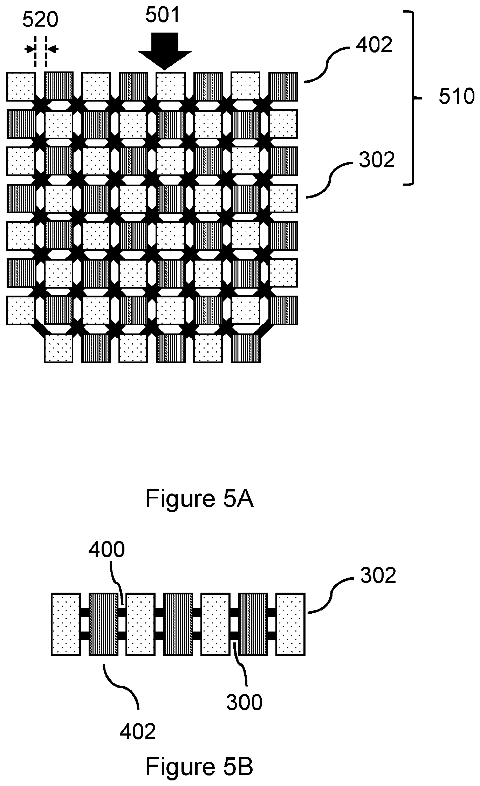

Figure 4B shows a side view of the thermoelectric array 402 from a viewing position 401, with the second frame 400 for the p-type thermoelectric elements having a different vertical position to the first frame 300 for the n-type thermoelectric elements. This then enables the n-type thermoelectric array 302 and the p-type thermoelectric array 402 to be simply slotted together as shown in Figure 5A, to form a combined thermoelectric array 510.

Figure 5A shows a side view of the combined thermoelectric array 510, seen from viewing position 501, showing how the different vertical positions of the first frame 300 and the second frame 400 avoids mechanical interference as the first frame 300 and the second frame 400 are slotted together. The combined thermoelectric assembly 510 can then be joined, e.g. by soldering or brazing, to the electrical interconnects and substrates without requiring alignment of each individual thermoelectric element 103, 104, thereby forming a thermoelectric module. Joining may be made in two steps, with a separate step for each substrate and associated electrical interconnects. To narrow the range of heights of the thermoelectric elements 103, 104, the thermoelectric elements 103, 104 may be ground, lapped or polished after being joined to the first substrate and electrical interconnects. Joining may occur in one step between the combined thermoelectric assembly and the two substrates and their electrical interconnects.

The n- and p-type thermoelectric arrays 302, 402 have minimum thermoelectric element separations 320, 420 and other points on the thermoelectric element surfaces have higher separations to the nearest thermoelectric element. The minimum thermoelectric element separation in the n- and p-type thermoelectric arrays 320, 420 is 1.41 (√2) times higher than the minimum thermoelectric element separation 520 in the combined thermoelectric array 510, which will correspond to the minimum thermoelectric element separation in a thermoelectric module. For example, the wall thicknesses of the moulds or dies required during formation by sintering of the n- and p-type elements 104, 103 correspond to the thermoelectric element separations, and are also governed by minimum thicknesses to ensure adequate mould or die mechanical strength during the thermoelectric material formation process, e.g. during pressing and sintering. Therefore, if a minimum die or mould thickness of *MDT* is required for mechanical strength, this invention allows a minimum thermoelectric element separation in the module of *MDT*/*1.41.* This contrasts with processes that simultaneously form, e.g. sinter, the n- and p-type material in one step where the minimum thermoelectric element separation is given by *MDT.* Lower thermoelectric element separation in the thermoelectric module is beneficial for improving performance, for example to improve heat pumping power per unit area in cooling or heating mode, or to increase electrical power produced per area when subject to a temperature difference.

The thermoelectric elements 103, 104 may be formed by any suitable process. The thermoelectric elements 103, 104 may be formed by sintering processes including but not limited to hot pressing, spark plasma sintering, hot isostatic pressing, extrusion or cold pressing followed by heat treatment. Cold pressing may also precede the other formation processing steps to increase ease of handling.

The thermoelectric elements 103, 104 may be formed by other 3D manufacturing processes, including printing, casting or dispensing, optionally followed by heat treatment; and selective laser melting. While these may not require a mould or die, limitations in material slumping, the minimum resolution of print/dispense/laser heads or printing screens/stencils etc. will lead to a minimum value on thermoelectric element separation 320, 420 that can be made in one formation step, analogous to *MDT.* Therefore the separate formation of the n- and p-type elements 104, 103 described in this invention can still beneficially reduce the thermoelectric element separation 520 in the thermoelectric module.

In an embodiment, the shape of the thermoelectric elements 103, 104 in plan view may have chamfered or rounded corners. This can reduce mechanical stress concentrations, improving robustness in the module. In addition it can decrease the minimum thermoelectric spacing 520 in the final module while maintaining the same *MDT* during manufacture of the thermoelectric arrays 302, 402. It may also improve release from the die or mould during thermoelectric array formation.

In an embodiment, the shape of the thermoelectric elements in plan view may be circular, for example forming cylindrical thermoelectric elements. This can reduce mechanical stress concentrations, improving robustness in the module and if a mould or die is required during formation it may also improve release from the die or mould during thermoelectric array formation.

In an embodiment, the shape of the thermoelectric elements in side view may be tapered, for example to aid release from a mould or die.

One of more of the frames, e.g. the first frame 300 and the second frame 400, may be made of an electrical insulator. The frame 300, 400 may be made from an electrical conductor. The frame 300, 400 may be made of the same thermoelectric material as the thermoelectric elements 103, 104. The frame 300, 400 may be made of metal, for example copper, silver, nickel, iron, cobalt, molybdenum or gold. The frame 300, 400 may be a wire, ribbon or foil. The frame 300, 400 may have more than one layer. The frame 300, 400 may be formed by cutting from a foil e.g. by die cutting.

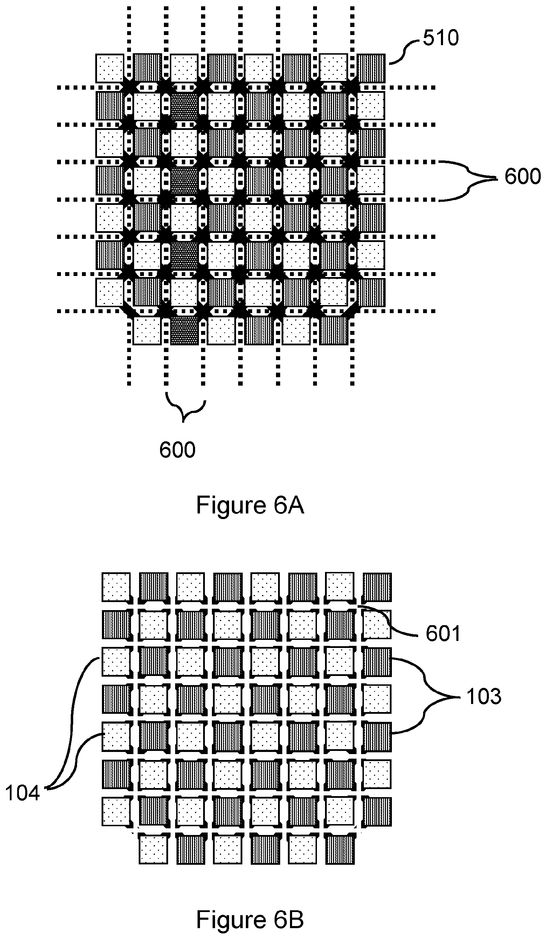

In embodiments where frame 300, 400 is made from an electrical conductor, the frame 300, 400 may provide an electrical short circuit of the thermoelectric elements 103, 104, reducing performance. Therefore, after mounting the combined thermoelectric array 510 on one side to either a temporary substrate or the electrical interconnects and substrate it may be necessary to cut the frames along cut lines 600 as shown in Figure 6A, resulting in removal of the frame's electrical short circuits in areas such as 601 as shown in Figure 6B. While this adds a further process step, compared to the conventional process this cutting process does not waste thermoelectric material, and can be performed at significantly higher speed, as only small quantities of frame material need to be removed. With correct choice of cutting blade or wire saw width, this cutting process may also be used to remove any undesirable imperfections in the edges of the thermoelectric elements caused by edge effects during production. Other methods of cutting the frame may also be used such as laser cutting or water jet cutting.

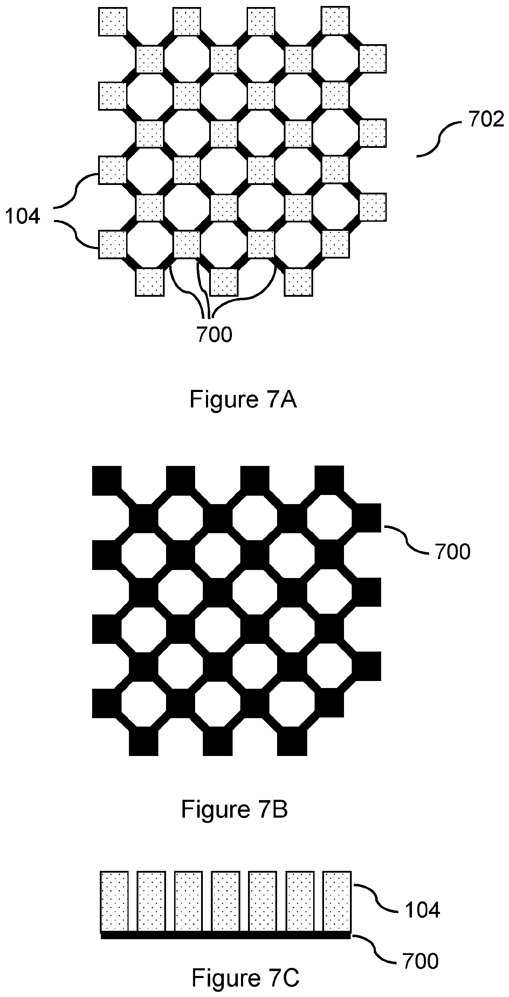

Figures 7A, 7B and 7C show another embodiment. Figure 7A shows a top plan view of the n-type thermoelectric elements 104, which are produced in their final shape, with the correct relative positioning for the thermoelectric module, with the help of a frame 700, to form an n-type thermoelectric array 702. The frame 700 extends across the thermoelectric area, with a plan view of the frame 700 only shown in Figure 7B. A side view of the thermoelectric array 702 is shown in Figure 7C, showing that in this case the frame 700 is positioned at one end of the n-type thermoelectric elements 104. A similar scheme may be employed for the p-type thermoelectric array.

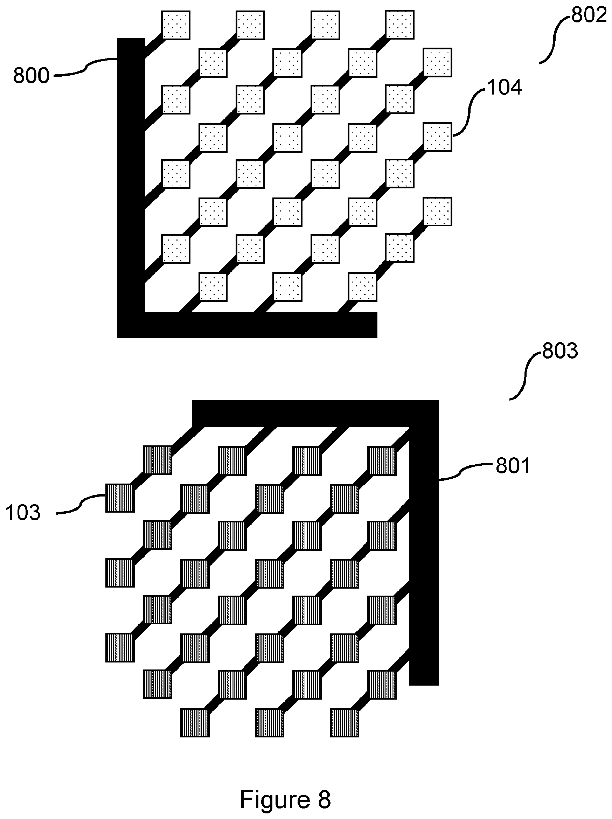

Figure 8 shows an embodiment where n-type thermoelectric elements 104 are joined by a frame 800 to form an n-type thermoelectric assembly 802. P-type thermoelectric elements 103 are joined by a frame 801 to form a p-type thermoelectric assembly 803. In this embodiment the frames 800, 801 are able to completely pass through each other (i.e. will not mechanically interfere).

In an embodiment two frames are used for each of the n-type and p-type thermoelectric elements, one at each end of the thermoelectric elements, so that two frames are used for each of the n-type thermoelectric array and the p-type thermoelectric array, making four frames in the combined thermoelectric assembly. The frames at a first end of the n-type and p-type thermoelectric array are of the type shown in Figure 8, so can pass through each other, while the frames at an opposing second end are of the type shown in Figure 7 and may provide increased mechanical strength. In this way metallisation layers can be applied to both sides of the thermoelectric elements while achieving net shape thermoelectric element manufacture and keeping the required relative spacing of the thermoelectric elements for the thermoelectric module.

In an example implementation, at least one of the first frame, the second frame, the third frame and the fourth frame may extend outside the minimum sized envelope required to enclose the thermoelectric elements. For instance, the envelope may be rectangular.

In an example implementation, at least one of the first frame, the second frame, the third frame and the fourth frame may be up to 10 mm thick. One or more of the frames may have a thickness of up to 5 mm, up to 4 mm, up to 3 mm, up to 2 mm or up to 1 mm. One of more of the frames may have a thickness of at least 5 microns or at least 10 microns. One or more of the frames may comprise a thickness in the range of from 5 to 1000 microns, from 5 to 500 microns, from 5 to 300 microns, from 10 to 1000 microns, from 10 to 500 microns or from 10 to 300 microns.

The separation between adjacent thermoelectric elements in the module may be less than 5 mm. The separation between adjacent thermoelectric elements in the module may be less than 1 mm. The separation between adjacent thermoelectric elements in the module may be less than 0.5 mm.

The number of thermoelectric elements attached to the frame may be at least four, at least eight or at least 16. For example, the number of thermoelectric elements attached to any given frame may lie in the range from 4 to 1024.

A single thermoelectric module may be produced from one or more combined thermoelectric arrays. A single thermoelectric module may be produced from a plurality of combined thermoelectric arrays. Although this may increase complexity of the joining process by requiring alignment of multiple combined thermoelectric arrays, smaller combined thermoelectric arrays may be made with a higher yield, while the use of the combined thermoelectric arrays still significantly reduces the number of individual items to place and align. For example, a thermoelectric module may be formed of 256 thermoelectric elements by using 4 combined thermoelectric arrays each having 64 thermoelectric elements.

Suitable thermoelectric materials for the thermoelectric elements may include, but are not limited to: bismuth telluride; bismuth selenide; antimony telluride; lead telluride; lead selenide; magnesium silicide; magnesium stannide; higher manganese silicide; skutterudite materials; Half Heusler alloys; silicon-germanium, oxides and combinations of the above. Suitable thermoelectric materials may include any binary, tertiary or quaternary compound, or any chemical composition, of the above listed elements (or any other elements), that exhibits favourable thermoelectric properties. The thermoelectric material may be crystalline or amorphous. The thermoelectric materials may include any suitable combination of dopants and/or other additives that may alter the chemical composition and/or thermoelectric properties.

The substrates may be made from electrically insulating, thermally conductive materials such as aluminium oxide, aluminium nitride or beryllium oxide. The electrical interconnects may be made of a conductive metal such as silver, copper or aluminium.

The thermoelectric elements within a given thermoelectric array may be arranged in a square array, i.e. the thermoelectric elements, which may be any shape, may be lined up in mutually perpendicular rows and columns. The thermoelectric elements within a given thermoelectric array may be arranged in a non-square array, e.g. a triangular or three-fold array or a hexagonal or six-fold array. The teaching of the disclosure may be applied to any arrangement of thermoelectric elements in the n-type thermoelectric array and the p-type thermoelectric array that can be slotted together to create a combined thermoelectric array, in which both the n-type elements and the p-type elements are in the correct relative positions for the thermoelectric module.

The n-type thermoelectric array comprises at least three net shaped n-type thermoelectric elements arranged on the first frame, e.g. at least four net shaped n-type thermoelectric elements arranged on the first frame.

The p-type thermoelectric array comprises at least three net shaped p-type thermoelectric elements arranged on the first frame, e.g. at least four net shaped p-type thermoelectric elements arranged on the first frame.

## Claims

1. A method of making a combined thermoelectric array (510) for use in a thermoelectric module comprising:
(a) forming an n-type thermoelectric array (302) by forming at least three net shaped n-type thermoelectric elements (104) in-situ on a first frame (300) such that the n-type thermoelectric elements are in the correct relative positions for use in the thermoelectric module;
(b) forming a p-type thermoelectric array (402) by forming at least three net shaped p-type thermoelectric elements (103) in-situ on a second frame (400) such that the p-type thermoelectric elements are in the correct relative positions for use in the thermoelectric module; and
(c) slotting together the n-type thermoelectric array and the p-type thermoelectric array, thereby creating a combined thermoelectric array (510), in which both the n-type elements and the p-type elements are in the correct relative positions for use in a thermoelectric module.

2. A method of making a combined thermoelectric array according to claim 1, wherein forming the n-type thermoelectric elements and/or the p-type thermoelectric elements comprises sintering an n-type thermoelectric material and/or a p-type thermoelectric material.

3. A method of making a combined thermoelectric array according to claim 1 or claim 2, wherein the n-type thermoelectric array includes at least four net shaped n-type thermoelectric elements and/or wherein the p-type thermoelectric array includes at least four net shaped p-type thermoelectric elements.

4. A method of making a combined thermoelectric array according to any one of the preceding claims, wherein the n-type thermoelectric array includes up to 1024 net shaped n-type thermoelectric elements and/or wherein the p-type thermoelectric array includes up to 1024 net shaped p-type thermoelectric elements.

5. A method of making a combined thermoelectric array according to any one of the preceding claims, wherein the first frame and the second frame are positioned near to or at opposing ends of the n-type and p-type thermoelectric elements respectively.

6. A method of making a combined thermoelectric array according to any one of the preceding claims, wherein the first frame and the second frame are configured such that, when slotting together the n-type thermoelectric array and the p-type thermoelectric array, the n-type thermoelectric array and the p-type thermoelectric array cannot fully pass through each other.

7. A method of making a combined thermoelectric array according to any one of the preceding claims, wherein at least one of the first frame and the second frame comprises a metal.

8. A method according to any one of the previous claims, wherein the n-type thermoelectric array comprises a third frame connected near to or at opposing ends of the thermoelectric elements to the first frame.

9. A method according to any one of the preceding claims, wherein the p-type thermoelectric array comprises a fourth frame connected near to or at opposing ends of the thermoelectric elements to the second frame.

10. A method of making a combined thermoelectric array according to any one of the preceding claims, wherein at least one of the n-type thermoelectric elements and/or the p-type thermoelectric elements comprises one or more of: bismuth telluride; bismuth selenide; antimony telluride; lead telluride; lead selenide; magnesium silicide; magnesium stannide; higher manganese silicide; skutterudite materials; Half Heusler alloys; silicon-germanium, oxides; and combinations thereof.

11. A method of making a thermoelectric module, comprising:
making a combined thermoelectric array using the method of any previous claim; and
joining the combined thermoelectric array to at least one interconnect and at least one substrate to form the thermoelectric module.

12. A method according to claim 11, wherein following the step of joining the combined thermoelectric array to at least one interconnect and at least one substrate, the first frame and/or the second frame is/are at least partially removed from the combined thermoelectric module.

## Patentansprüche

1. Verfahren zum Herstellen einer kombinierten thermoelektrischen Anordnung (510) zur Verwendung in einem thermoelektrischen Modul, umfassend:
(a) Bilden einer thermoelektrischen Anordnung (302) vom Typ n durch Bilden von mindestens drei netzförmigen thermoelektrischen Elementen (104) vom Typ n vor Ort auf einem ersten Rahmen (300) derart, dass die thermoelektrischen Elemente vom Typ n in den richtigen relativen Positionen zur Verwendung in dem thermoelektrischen Modul sind;
(b) Bilden einer thermoelektrischen Anordnung (402) vom Typ p durch Bilden von mindestens drei netzförmigen thermoelektrischen Elementen (103) vom Typ p vor Ort auf einem zweiten Rahmen (400) derart, dass die thermoelektrischen Elemente vom Typ p in den richtigen relativen Positionen zur Verwendung in dem thermoelektrischen Modul sind; und
(c) Zusammenfügen der thermoelektrischen Anordnung vom Typ n und der thermoelektrischen Anordnung vom Typ p, dadurch Erzeugen einer kombinierten thermoelektrischen Anordnung (510), in der sowohl die Elemente vom Typ n als auch die Elemente vom Typ p in den richtigen relativen Positionen zur Verwendung in einem thermoelektrischen Modul sind.

2. Verfahren zum Herstellen einer kombinierten thermoelektrischen Anordnung nach Anspruch 1, wobei das Bilden der thermoelektrischen Elemente vom Typ n und/oder der thermoelektrischen Elemente vom Typ p Sintern eines thermoelektrischen Materials vom Typ n und/oder eines thermoelektrischen Materials vom Typ p umfasst.

3. Verfahren zum Herstellen einer kombinierten thermoelektrischen Anordnung nach Anspruch 1 oder Anspruch 2, wobei die thermoelektrische Anordnung vom Typ n mindestens vier netzförmige thermoelektrische Elemente vom Typ n beinhaltet und/oder wobei die thermoelektrische Anordnung vom Typ p mindestens vier netzförmige thermoelektrische Elemente vom Typ p beinhaltet.

4. Verfahren zum Herstellen einer kombinierten thermoelektrischen Anordnung nach einem der vorhergehenden Ansprüche, wobei die thermoelektrische Anordnung vom Typ n bis zu 1024 netzförmige thermoelektrische Elemente vom Typ n beinhaltet und/oder wobei die thermoelektrische Anordnung vom Typ p bis zu 1024 netzförmige thermoelektrische Elemente vom Typ p beinhaltet.

5. Verfahren zum Herstellen einer kombinierten thermoelektrischen Anordnung nach einem der vorhergehenden Ansprüche, wobei der erste Rahmen und der zweite Rahmen in der Nähe von oder an gegenüberliegenden Enden der thermoelektrischen Elemente vom Typ n bzw. vom Typ p positioniert werden.

6. Verfahren zum Herstellen einer kombinierten thermoelektrischen Anordnung nach einem der vorhergehenden Ansprüche, wobei der erste Rahmen und der zweite Rahmen derart konfiguriert sind, dass die thermoelektrische Anordnung vom Typ n und die thermoelektrische Anordnung vom Typ p einander beim Zusammenfügen der thermoelektrischen Anordnung vom Typ n und der thermoelektrischen Anordnung vom Typ p nicht vollständig durchdringen können.

7. Verfahren zum Herstellen einer kombinierten thermoelektrischen Anordnung nach einem der vorhergehenden Ansprüche, wobei mindestens einer des ersten Rahmens und des zweiten Rahmens ein Metall umfasst.

8. Verfahren nach einem der vorstehenden Ansprüche, wobei die thermoelektrische Anordnung vom Typ n einen dritten Rahmen umfasst, der in der Nähe von oder an gegenüberliegenden Enden der thermoelektrischen Elemente mit dem ersten Rahmen verbunden wird.

9. Verfahren nach einem der vorhergehenden Ansprüche, wobei die thermoelektrische Anordnung vom Typ p einen vierten Rahmen umfasst, der in der Nähe von oder an gegenüberliegenden Enden der thermoelektrischen Elemente mit dem zweiten Rahmen verbunden wird.

10. Verfahren zum Herstellen einer kombinierten thermoelektrischen Anordnung nach einem der vorhergehenden Ansprüche, wobei mindestens eines der thermoelektrischen Elemente vom Typ n und/oder der thermoelektrischen Elemente vom Typ p eines oder mehrere der Folgenden umfasst: Bismuttellurid; Bismutselenid; Antimontellurid; Bleitellurid; Bleiselenid; Magnesiumsilicid; Magnesiumstannid; höheres Mangansilicid; Skutterudit-Materialien; Halb-Heusler-Legierungen; Silizium-Germanium, Oxide; und Kombinationen davon.

11. Verfahren zum Herstellen eines thermoelektrischen Moduls, umfassend:
Herstellen einer kombinierten thermoelektrischen Anordnung unter Verwendung des Verfahren nach einem der vorstehenden Ansprüche; und
Verbinden der kombinierten thermoelektrischen Anordnung mit mindestens einer Zusammenschaltung und mindestens einem Substrat zum Bilden des thermoelektrischen Moduls.

12. Verfahren nach Anspruch 11, wobei im Anschluss an den Schritt des Verbindens der kombinierten thermoelektrischen Anordnung mit mindestens einer Zusammenschaltung und mindestens einem Substrat der erste Rahmen und/oder der zweite Rahmen mindestens teilweise von dem kombinierten thermoelektrischen Modul entfernt wird/werden.

## Revendications

1. Procédé de fabrication d'un réseau thermoélectrique combiné (510) pour une utilisation dans un module thermoélectrique comprenant :
(a) la formation d'un réseau thermoélectrique de type n (302) par la formation d'au moins trois éléments thermoélectriques de type n de forme nette (104) in situ sur un premier cadre (300) de telle sorte que les éléments thermoélectriques de type n soient dans les positions relatives correctes pour une utilisation dans le module thermoélectrique ;
(b) la formation d'un réseau thermoélectrique de type p (402) par la formation d'au moins trois éléments thermoélectriques de type p de forme nette (103) in situ sur un deuxième cadre (400) de telle sorte que les éléments thermoélectriques de type p soient dans les positions relatives correctes pour une utilisation dans le module thermoélectrique ; et
(c) l'emboîtement du réseau thermoélectrique de type n et du réseau thermoélectrique de type p, créant ainsi un réseau thermoélectrique combiné (510), dans lequel à la fois les éléments de type n et les éléments de type p sont dans les positions relatives correctes pour une utilisation dans un module thermoélectrique.

2. Procédé de fabrication d'un réseau thermoélectrique combiné selon la revendication 1, dans lequel la formation des éléments thermoélectriques de type n et/ou des éléments thermoélectriques de type p comprend le frittage d'un matériau thermoélectrique de type n et/ou d'un matériau thermoélectrique de type p.

3. Procédé de fabrication d'un réseau thermoélectrique combiné selon la revendication 1 ou la revendication 2, dans lequel le réseau thermoélectrique de type n inclut au moins quatre éléments thermoélectriques de type n de forme nette et/ou dans lequel le réseau thermoélectrique de type p inclut au moins quatre éléments thermoélectriques de type p de forme nette.

4. Procédé de fabrication d'un réseau thermoélectrique combiné selon l'une quelconque des revendications précédentes, dans lequel le réseau thermoélectrique de type n inclut jusqu'à 1024 éléments thermoélectriques de type n de forme nette et/ou dans lequel le réseau thermoélectrique de type p inclut jusqu'à 1024 éléments thermoélectriques de type p de forme nette.

5. Procédé de fabrication d'un réseau thermoélectrique combiné selon l'une quelconque des revendications précédentes, dans lequel le premier cadre et le deuxième cadre sont positionnés à proximité de ou au niveau d'extrémités opposées des éléments thermoélectriques de type n et de type p respectivement.

6. Procédé de fabrication d'un réseau thermoélectrique combiné selon l'une quelconque des revendications précédentes, dans lequel le premier cadre et le deuxième cadre sont configurés de telle sorte que, lors de l'emboîtement du réseau thermoélectrique de type n et du réseau thermoélectrique de type p, le réseau thermoélectrique de type n et le réseau thermoélectrique de type p ne peuvent pas passer complètement l'un à travers l'autre.

7. Procédé de fabrication d'un réseau thermoélectrique combiné selon l'une quelconque des revendications précédentes, dans lequel au moins l'un du premier cadre et du deuxième cadre comprend un métal.

8. Procédé selon l'une quelconque des revendications précédentes, dans lequel le réseau thermoélectrique de type n comprend un troisième cadre connecté à proximité de ou au niveau d'extrémités opposées des éléments thermoélectriques par rapport au premier cadre.

9. Procédé selon l'une quelconque des revendications précédentes, dans lequel le réseau thermoélectrique de type p comprend un quatrième cadre connecté à proximité de ou au niveau d'extrémités opposées des éléments thermoélectriques par rapport au deuxième cadre.

10. Procédé de fabrication d'un réseau thermoélectrique combiné selon l'une quelconque des revendications précédentes, dans lequel au moins un des éléments thermoélectriques de type n et/ou des éléments thermoélectriques de type p comprend un ou plusieurs parmi : le tellurure de bismuth ; le séléniure de bismuth ; le tellurure d'antimoine ; le tellurure de plomb ; le séléniure de plomb ; le siliciure de magnésium ; le stannure de magnésium ; le siliciure de manganèse supérieur ; les matériaux skuttérudites ; les alliages Half Heusler ; le silicium-germanium, les oxydes ; et les combinaisons de ceux-ci.

11. Procédé de fabrication d'un module thermoélectrique, comprenant :
la fabrication d'un réseau thermoélectrique combiné en utilisant le procédé de l'une quelconque des revendications précédentes ; et
la jonction du réseau thermoélectrique combiné à au moins une interconnexion et au moins un substrat pour former le module thermoélectrique.

12. Procédé selon la revendication 11, dans lequel, suite à l'étape consistant à joindre le réseau thermoélectrique combiné à au moins une interconnexion et au moins un substrat, le premier cadre et/ou le deuxième cadre est/sont au moins partiellement retiré(s) du module thermoélectrique combiné.
